# EUROPÄISCHE PATENTSCHRIFT

(11) **EP 0 484 276 B1**
(45) Veröffentlichungstag und Bekanntmachung des Hinweises auf die Patenterteilung: **22.11.1995**
(21) Anmeldenummer: 91810810.1
(22) Anmeldetag: 21.10.1991
(51) Int. Cl.: G02B 27/00, G02B 27/12, H01S 3/23, H01S 3/25, G02B 13/08

(54) **Verfahren, bei dem mehrere, in einer oder mehreren Reihen angeordnete Strahlungsquellen abgebildet werden und Vorrichtung hierzu**
Method for imaging several radiation sources arranged in one or more rows, and device for implementing the method
Méthode de formation de l'image de sources de radiation alignées en une ou plusieurs colonnes et dispositif l'utilisant

(30) Priorität: 01.11.1990 CH 3474/90
(43) Veröffentlichungstag der Anmeldung: 06.05.1992
(73) Patentinhaber: FISBA OPTIK AG, 9016 St. Gallen (CH); Bystronic Laser AG, CH-3362 Niederönz (CH)
(72) Erfinder: Albers, Peter, Dr., CH-1005 Lausanne (CH); Langenbach, Eckhard, CH-9014 St. Gallen (CH); Heimbeck, Hans-Jörg, Dr., CH-9435 Heerbrugg (CH)
(74) Vertreter: Keller, René, Dr.

(56) Entgegenhaltungen:
- EP-A- 0 232 037
- EP-A- 0 310 711
- WO-A-90/00752
- US-A- 4 185 891
- US-A- 4 306 278
- Opt. Lett., Vol. 14, 1057-1059 (1989)
- Appl. Phys. Lett., Vol.51, 1212-1214 (1987)
- Opt. Eng., Vol. 27, 830-834 (1988)

## Beschreibung

Die Erfindung betrifft ein Verfahren gemäß dem Oberbegriff des Patentanspruchs 1 und eine Vorrichtung gemäß dem Oberbegriff des Patentanspruchs 4.
Ein Verfahren und eine Vorrichtung dieser Art ist aus T.Y. Fan et al., "Scalable, end-pumped, diode-laser-pumped laser", Opt. Lett., Vol. 14, No. 19, Oct. 1, 1989 S. 1057 - 1059 bekannt. Es wurde hier die Ausgangsstrahlung dreier senkrecht zu ihren p-n-Ebenen übereinander angeordneten Diodenlaserarrays mit je einer sphärischen Linse und drei hintereinander folgenden Zylinderlinsen stirnseitig in einen ND:YAG-Laserkristall fokussiert, um diesen optisch anzuregen. Durch die sphärischen Linsen mit einer Brennweite von 0,4 cm und einer numerischen Apertur von 0,47 wurden die Strahlen der Diodenlaser senkrecht zur p-n-Ebene kollimiert. Mit der nachfolgenden ersten Zylinderlinse erfolgt dann eine Kollimierung in der hierzu senkrechten Richtung und mit den nachfolgenden zweiten und dritten Zylinderlinsen eine Fokussierung stirnseitig in den ND:YAG-Kristall.

Eine andere Anordnung zur Fokussierung der Strahlen eines mehrere Dioden aufweisenden Diodenlaserarrays ist aus der EP-A 0 310 711 sowie aus J.Berger et al., "High power, high efficient neodymium:yttrium aluminium garnet laser end pumped by a laser diode array, Appl. Phys. Lett. 51(16), 19 Oct. 1987, S. 1212 - 1214 bekannt. Eine Vereinigung zweier kollimierter Strahlen von Laserdioden zu einem einzigen Strahl und dessen Fokussierung in ein laseraktives Medium beschrieb R. Scheps, et al., in "End-pumped Nd:BEL laser performance", Optical Engineering, Sept. 1988, Vol. 27, No.9, S. 830 - 834 bekannt.

Zylinderlinsen gehören zu den nichtzentrisch abbildenden Funktionselementen (Heinz Haferkorn, "Optik", VEB Deutscher Verlag der Wissenschaften, Berlin, 1980, S. 244). Ein abbildendes Funktionselement ist eine konkrete Struktur, die als Ganzes in einer modellmäßig bestimmten Umgebung vorgegebene optische Eingangsgrößen in vorgegebene optische Ausgangsgrößen überführt. Unter dem Öffnungswinkel wird der Winkel zwischen zwei Meßpunkten verstanden, die in einer auf der abstrahlenden Fläche senkrecht stehenden Ebene in gleichem radialen Abstand von der Mitte der Schnittlinie der Ebene mit der abstrahlenden Fläche liegen, wobei der eine Meßpunkt senkrecht über der Mitte liegt und der andere Meßpunkt an dem Ort liegt, an dem die ausgesandte Intensität gegenüber der maximalen in dieser Ebene gemessenen Intensität auf den 1/e²-ten Teil abgesunken ist.

Wie insbesonders aus T.Y. Fan et al., "Scalable, end-pumped, diode-laser-pumped laser", Opt. Lett., Vol. 14, No. 19, Oct. 1, 1989 S. 1057 - 1059 hervorgeht, müssen die Strahlungsquellen und die Linsen sorgfältig ausgerichtet werden.

Der Erfindung liegt die Aufgabe zugrunde, ein Verfahren und eine Vorrichtung zu schaffen, welche eine gute optische Abbildung von handelsüblichen, in einer oder mehreren Reihen angeordneten Strahlungsquellen mit nicht rotationssymmetrischer Ausstrahlungsintensitätsverteilung erlaubt.

Die Aufgabe wird hinsichtlich des Verfahrens durch den Patentanspruch 1 und hinsichtlich der Vorrichtung durch den Patentanspruch 4 gelöst. Bevorzugte Ausführungs arten des Verfahrens sind in den Patentansprüchen 2 und 3 und der Vorrichtung in den Patentansprüchen 5 bis 11 beschrieben.

Im folgenden wird ein Beispiel einer erfindungsgemäßen Vorrichtung und eines erfindungsgemäßen Verfahrens anhand der Zeichnungen näher erläutert. Es zeigen:
- Fig. 1: eine schematische Draufsicht auf eine Vorrichtung, mit der fünf Diodenlaser in einen Raumbereich abgebildet werden,
- Fig. 2: eine Seitenansicht der in **Figur 1** dargestellten Vorrichtung,
- Fig. 3: eine Seitenansicht des unmittelbar vor einem der Diodenlaser angeordneten nichtzentrisch abbildenden Funktionselements,
- Fig. 4: eine um 45° geneigte Darstellung des Strahlengangs durch ein Abbé-König-Prisma zur einseitigen Bildumkehr in der Vorrichtung,
a. die Eingangslage eines auf das Abbé-König-Prisma auftreffenden Strahls eines der Diodenlaser in Blickrichtung IVa - IVa in **Figur 4b**,
b. den Strahlengang durch das Abbé-König-Prisma, und
c. die Ausgangslage des das Abbé-König-Prisma verlassenden Strahls in Blickrichtung IVc - IVc in **Figur 4b**.

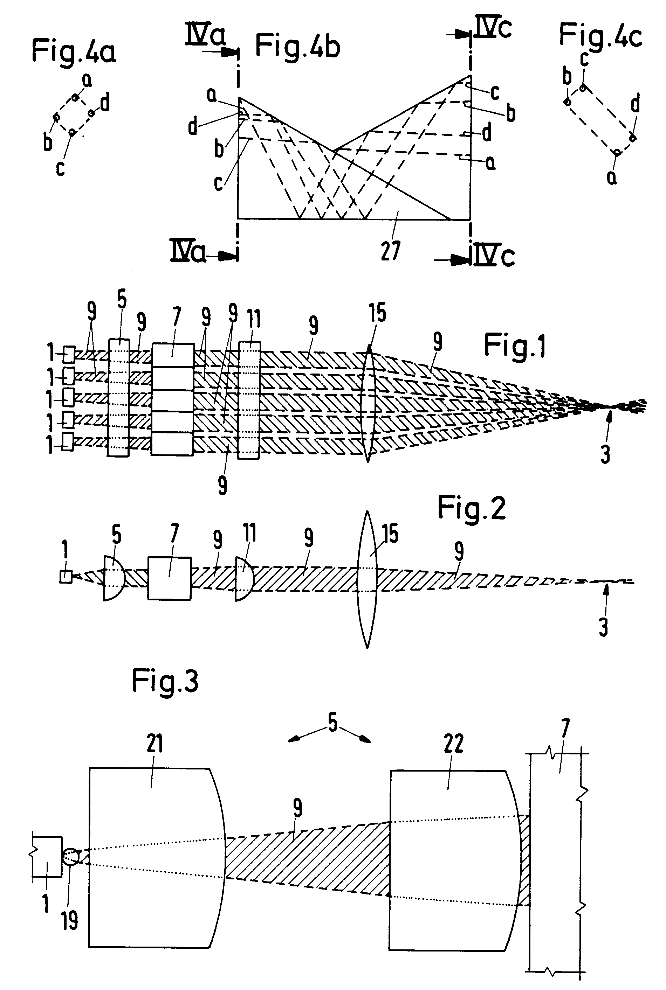

Mir der in den Figuren 1 und 2 dargestellten Vorrichtung wird die Strahlung von fünf in einer Reihe liegenden Diodenlasern 1 in einen Raumbereich 3 fokussiert. Jeder Diodenlaser **1** besteht aus vierzig in einer Reihe zueinander parallel angeordneten, integrierten, phasengekoppelten, strahlungsemittierenden Streifen. Als Raumbereich **3** kann z. B. die Stirnfläche eines nicht dargestellten Lasers, der mit der Strahlung der Diodenlaser **1** optisch angeregt werden soll oder die Stirnfläche einer nicht dargestellten optischen Faser, dienen, in welche die Strahlung der Diodenlaser **1** eingekoppelt werden soll. In der Draufsicht in **Figur 1** liegt die p-n-Ebene der Diodenlaser **1** in der Zeichenblattebene und in **Figur 2** senkrecht hierzu. Wie aus den **Figuren 1** und **2** ersichtlich, ist die Strahlung der Diodenlaser **1** annähernd spiegel-, aber nicht rotationssymmetrisch. Die Strahlung aller Diodenlaser **1** ist in ihrer Ausstrahlungscharakteristik zueinander ähnlich. Der Öffnungswinkel jedes Strahlenbündels **9** der Diodenlaser **1** ist in der Ebene parallel zur p-n-Ebne am kleinsten und senkrecht zu ihr am größten. Vor den Diodenlasern **1** ist ein als Zylinderlinse wirkendes nichtzentrisch abbildendes Funktionselement **5** angeordnet, dessen Zylinderachse in der p-n-Ebene liegt. Auf das Funktionselement **5** folgt ein weiteres unten beschriebenes optisches Bauteil **7**, welches den Strahl 9 jedes Diodenlasers **1** um 90 ° gedreht erscheinen läßt. Nach dem optischen Bauteil **7** folgt wieder ein als Zylinderlinse wirkendes nichtzentrisch abbildendes Funktionselement **11**, dessen Zylinderachse ebenfalls in der p-n-Ebene liegt. Die Ausgangsstrahlung des Funktionselements **11** wird mit einer sphärischen Linse **13** als zentrisch abbildendem Funktionselement in den Raumbereich **3** fokussiert.

Der Abstand der Hauptebene des Funktionselements **5** von der Vorderfläche der Diodenlaser **1** entspricht seiner Brennweite. Die Brennweite und die Apertur des Funktionselementes **5** sind so gewählt, daß der abgebildete Strahl **9** in die Apertur des optischen Bauteils **7** paßt. Der Abstand des Funktionselementes **11** von den Vorderflächen der Diodenlaser **1** ist unter Berücksichtigung des optischen Weges durch das optische Bauteil **7** um eine kleine Toleranz größer als dessen Brennweite. Das optische Bauteil **7** ist zwischen den beiden Funktionselementen **5** und **11** angeordnet. Der Abstand der sphärischen Linse **13** von dem Raumbereich **3** entspricht ihrer Brennweite.

Die von den Diodenlasern **1** emittierten Strahlenbündel **9** durchlaufen das Funktionselement **5**, welches die Strahlen 9 in Richtung des kleinsten Strahlparameterprodukts (größter Strahlöffnungswinkel kollimiert wie in **Figur 2** dargestellt. Senkrecht zur p-n-Ebene haben die von den Diodenlasern **1** ausgesandten Strahlen **9** ihren größten Öffnungswinkel. Alle Strahlbereiche welche in zur p-n-Ebene der Diodenlaser **1** parallelen Ebenen liegen, durchlaufen das Funktionselement **5** unverändert, wie in **Figur 1** dargestellt; es erfolgt nur eine geringe Strahlverschiebung in Richtung der optischen Achse, hervorgerufen durch den gegenüber Luft höheren Brechungsindex des Funktionselements **5**. Parallel zur p-n-Ebene haben die von den Diodenlasern **1** ausgesandten Strahlen **9** ihren kleinsten Öffnungswinkel. Durch das optische Bauteil **7** wird jeder Strahl **9** um 90 ° gedreht. D. h. die kollimierten Strahlbereiche sind jetzt hinter dem optischen Bauteil **7** in **Figur 1** und die unbeeinflußten Strahlbereiche hinter dem optischen Bauteil **7** in **Figur 2** zu sehen. Zur Kenntlichmachung wurde für die gedrehten Strahlen **9** eine unterschiedliche Schraffur gewählt. Mit dem Funktionselement **11** werden nun die noch unbeeinflußten Strahlbereiche ebenfalls kollimiert (parallel gerichtet).

Durch die oben beschriebene Vorrichtung, deren abbildende Funktionselemente **5** und **11** sowie deren optische Bauteil **7** unten beschreiben sind, ergibt sich eine gute Fokussierbarkeit für mehrere Einzelstrahlen. Die gute Fokussierbarkeit wird dadurch erreicht, daß die Strahlen **9** mehrerer Diodenlaser **1** derart überlagert werden, daß das nicht mit optischen Funktionselementen zu verbessernde schlechte Strahlparameterprodukt in einer Ebene senkrecht zur Strahlachse beibehalten wurde und nur das beste Strahlparameterprodukt der Strahlen **9** durch die Überlagerung verschlechtert wurde.

Als Maß für die Fokussierbarkeit eines Strahlenbündels **9** dient das Strahlparameterprodukt (englisch "beam quality product"). Das Strahlparameterprodukt ist das Produkt der numerischen Apertur multipliziert mit dem halben Durchmesser der strahlenden Fläche. Je kleiner dieses Produkt ist, desto besser ist die Fokussierbarkeit.

Für das Zahlenbeispiel werden fünf Diodenlaser **1** angenommen, deren strahlende Flächen jeweils 400 µm x 1 µm betragen. Die große Breite der Fläche von 400 µm liegt in der p-n-Ebene. Die Höhe von 1 µm liegt senkrecht zur p-n-Ebene. Die 400 µm haben einen Öffnungswinkel von etwa 5 °, d. h. eine numerische Apertur von etwa 0,1 und die 1 µm einen Öffnungswinkel von 20 ° bis 30 °, d. h. eine numerische Apertur von etwa 0,4. Sämtliche p-n-Ebenen der Diodenlaser **1** liegen in einer Ebene bzw. parallel zueinander. Die einzelnen Diodenlaser **1** sind 2mm voneinander distanziert.

Obiges Strahlparameterprodukt ergibt nun bei der Betrachtung nur einer einzelnen Diode, bei der integriert vierzig Streifen linear angeordnet sind, in der p-n-Ebene der Einzeldioden einen Wert von 20 µm und senkrecht dazu einem Wert von 0,2 µm. D. h. die Fokussierbarkeit ist bei dieser vereinfachten Betrachtungsweise in der p-n-Ebene einhundert Mal schlechter als senkrecht zur p-n-Ebene.

Durch die Abbildung mit der oben beschriebenen Vorrichtung wird obiges Strahlparameterprodukt für den Öffnungswinkel von 20 bis 30 ° nicht verändert. Das Strahlparameterprodukt von 0,2 µm für den Öffnungswinkel von etwa 5° ergibt für die fünf Diodenlaser **1** bei einer Abbildung, in welcher der strahlungsfreie Zwischenraum zwischen jeweils zwei Strahlen **9** so breit ist wie der Strahl **9** selbst (d. h. ein optisches Tastverhältnis von 2) 0,2 µm x 5 x 2 = 2,0 µm. D.h. es könnten theoretisch fünfzig Diodenlaser **1** mit obigen Daten nebeneinander angeordnet werden, erst dann ist ein Strahlparameterprodukt in allen Ebenen senkrecht zur Ausbreitungsrichtung der Strahlen **9** von 20 µm erreicht.

Im nachfolgenden wird ein beispielsweiser Aufbau der Vorrichtung beschrieben. Das erste nichtzentrisch abbildende Funktionselement **5** hat, wie in **Figur 3** dargestellt, ausgehend von den Diodenlasern **1** einen Vollzylinder **19** aus Quarzglas mit einem Durchmesser vom 200 µm und zwei gleichen plankonvexen Zylinderlinsen **21** und **22** aus SFL6 mit einer Dicke von 1,44 mm. Der Radius der Zylinderlinsen **21** und **22** beträgt 3,56 mm. Beide Zylinderlinsen **21** und **22** sind 1,82 mm voneinander distanziert. Die Zylinderlinse **21** hat einen Abstand von 0,1 mm vom Vollzylinder **19** und die Zylinderlinse **22** einen Abstand von 0,1 mm vom optischen Bauteil **7**. Für einen Öffnungswinkel von ± 30 ° am Eingang des Funktionselements **5** ergibt sich eine Strahlhöhe von ± 0,5 mm.

Das zweite nichtzentrisch abbildende Funktionselement **11** besteht aus einer einzigen plankonvexen Zylinderlinse aus SFL6 mit einer Dicke von 3 mm, deren Achse parallel zur p-n-Ebene liegt. Der Radius der Zylinderlinse beträgt 35,6 mm. Die plane Fläche der Zylinderlinse ist 32 mm vom Ausgang des optischen Bauteils **7** entfernt angeordnet.

Als optisches Bauteil **7** wird für jeden einzelnen Diodenlaser **1** ein Abbé-König-Prisma **27** verwendet. Das Abbé-König-Prisma **27** ist um seine Symmetrieebene und um die Symmetrieebene jedes Strahls **9** um 45 ° in der optischen Achse gedreht. Der einfacheren Darstellung wegen wurde das Abbé-König-Prisma **27** in **Figur 4b** unter einer um 45 ° seitlich geneigten Anschicht dargestellt. **Figur 4a** zeigt den auf das Abbé-König-Prisma **27** auftreffenden Strahl **9** und **Figur 4c** den das Prisma **27** verlassenden Strahl **9** ebenfalls in einer um 45 ° gedrehten Darstellung. Die Randstrahlen des rechteckigen Strahls **9** sind mit **a, b, c** und **d** bezeichnet. Die Strahlbegrenzungen **a - b** und **c - d** in **Figur 4a** wurden bereits durch das Funktionselement **5** parallel gerichtet, wodurch sich deren Abstand **a/d** bzw. **b/c** auch nach Durchlaufen des Prismas **27** nicht verändert. Während die noch nicht durch das Funktionselement **11** abgebildeten Strahlbegrenzungen **a - d** und **b - c** aufgrund des Öffnungswinkels des aus der betreffenden Diode **1** austretenden Strahls **9** auseinanderlaufen, wie durch den vergrößerten Abstand **a/b** und **d/c** in **Figur 4c** zu sehen ist. Die Verdrehung des Strahls **9** durch das Prisma **27** ist daran zu erkennen, daß in **Figur 4a** der Randstahl **a** oben und in **Figur 4c** unten und der Randstahl **c** in **Figur 4a** unten und in **Figur 4c** oben ist. Die Randstrahlen **b** und **d** werden seitlich nicht vertauscht.

Die Funktionselemente **5** und **11** sowie das optische Bauteil **7** erzeugen aus den Strahlen **9** der fünf Diodenlaser **1**, die in einem Raster von 2 mm aufgereiht sind, fünf rechteckige Strahlen parallelen Lichts mit 1 mm Breite in gleichem Raster.

Durch nicht dargestellte Spiegelkämme können in die Zwischenräume zwischen den Strahlen weitere Strahlen einer zweiten Vorrichtung eingespiegelt werden.

Die Höhe der rechteckigen Strahlen **9** ist durch die Brennweite des zweiten Funktionselements **11** beliebig einstellbar. Sie beträgt hier mit den obigen Beispielswerten etwa ± 4,5 mm. Der Gesamtstrahlquerschnitt ist damit bei den fünf Diodenlaser etwa 9 mm x 9 mm groß. Jegliche Art von Strahlquerschnitt ist durch geeignete Wahl der Funktionselemente einstellbar.

Anstelle des Abbé-König-Prismas **27**, können je nach spezieller Anwendung u. a. Schmidt-Pechan-Prismen, Leman-Springer-Prismen, etc. verwendet werden.

Anstelle der sphärischen Linse **15** können auch zwei zueinander senkrecht stehende, nicht dargestellte Zylinderlinsen verwendet werden.

Die Auswahl der abbildenden Funktionselemente richtet sich nach den Öffnungswinkeln der Diodenlaser **1**. Es ist somit nicht zwingend notwendig, daß die Abbildung ausgehend von den Diodenlasern **1** als Strahlungsquellen mit einer nichtzentrischen Abbildung, dann einer Strahldrehung und einer weiteren nichtzentrischen Abbildung durchgeführt wird. Es kann auch ausgehend von den Diodenlasern **1** als erstes eine Strahldrehung vorgenommen werden.

## Patentansprüche

1. Verfahren zum Abbilden von mehreren Strahlungsquellen **(1)** in einen vorgegebenen Raumbereich **(3)**,
die in einer oder mehreren Reihen angeordnet sind,
die einen nicht rotationssymmetrischen Strahlquerschnitt aufweisen und
die so orientiert sind,
daß jeweils ihr größtes Strahlparameterprodukt in der Richtung auftritt,
in der die Strahlungsquellen einer Reihe angeordnet sind, wobei
unter Strahlparameterprodukt das Produkt aus der radialen Ausdehnung des Strahls **(9)** an der Quelle mit der numerischen Apertur zu verstehen ist,
bei welchem Verfahren der nicht rotationssymmetrische Strahlquerschnitt des Strahls aus jeder Strahlquelle beim Durchgang durch ein optisches Bauteil (7) in eine Lage überführt wird, die einer Drehung um denjenigen Winkel entspricht, den die Richtung des größten mit der Richtung des kleinsten Strahlparameterprodukts jeder Strahlquelle einschließt.

2. Verfahren nach Anspruch 1, bei dem mindestens ein erster Abbildungsschritt nichtzentrisch vor der Bilddrehung jedes Strahlenbündels **(9)** durchgeführt wird.

3. Verfahren nach Anspruch 2, mit dem die Strahlung **(9)** mindestens eines Diodenarrays **(1)** abgebildet wird, bei dem
die Strahlen des Diodenstrahlenbündels **(9)** im ersten Abbildungsschritt in Richtung des kleinsten Strahlparameterprodukts kollimiert werden, dann durch das optische Bauteil **(7)** geführt und anschließend
in der um den Drehwinkel gedrehten Richtung des größten Strahlparameterprodukts kollimiert und in einen Raumbereich **(3)** fokussiert werden.

4. Vorrichtung zum Abbilden von mehreren Strahlungsquellen **(1)** in einem vorgegebenen Raumbereich **(3)**,
die in einer oder mehreren Reihen angeordnet sind,
die einen nicht rotationssymmetrischen Strahlquerschnitt mit einem größten und einem kleinsten Strahlöffnungswinkel aufweisen und
die so orientiert sind, daß
jeweils ihr größtes Strahlparameterprodukt in der Richtung auftritt, in der
die Strahlquellen einer Reihe angeordnet sind, wobei unter Strahlparameterprodukt das Produkt aus der radialen Ausdehnung des Strahls **(9)** an der Quelle mit der numerischen Apertur zu verstehen ist,
bestehend aus mindestens einem ersten und einem zweiten abbildenden Funktionselement **(5, 11, 15), dadurch gekennzeichnet**, daß
für jede Strahlungsquelle **(1)** ein optisches Bauteil **(7)** für eine Bilddrehung vorgesehen ist,
welches so angeordnet ist, daß
nach dem Durchgang des Strahls **(9)** durch das Bauteil **(7)** der nicht rotationssymmetrische Strahlquerschnitt um annähernd den Winkel, insbesondere um 90°, gedreht erscheint, den
die Richtung des größten mit der Richtung des kleinsten Strahlparameterprodukts der Strahlungsquelle **(1)** einschließt.

5. Vorrichtung nach Anspruch 4, **dadurch gekennzeichnet**, daß
zwischen den Strahlungsquellen **(1)** und dem optischen Bauteil **(7)**, insbesondere einem Umkehrprisma,
das erste nichtzentrisch abbildende Funktionselement **(5)** angeordnet ist, mit dem
der Öffnungswinkel in Richtung des kleinsten Strahlparameterprodukts jeder Strahlungsquelle **(1)**, d.h. der größte Strahlöffnungswinkel verringerbar ist.

6. Vorrichtung nach Anspruch 4 oder 5, **dadurch gekennzeichnet**, daß
zwischen dem optischen Bauteil **(7)** und dem Raumbereich **(3)** das zweite nichtzentrisch abbildende Funktionselement **(11)** angeordnet ist, mit dem
der an der Quelle **(1)** austretende kleinste Strahlöffnungswinkel verringerbar ist.

7. Vorrichtung nach Anspruch 6 **dadurch gekennzeichnet**, daß
zwischen dem Raumbereich **(3)** und dem zweiten Funktionselement **(11)** ein zentrisch fokussierendes Funktionselement **(15)** zur Fokussierung der Strahlenbündel **(9)** in den Raumbereich **(3)** angeordnet ist.

8. Vorrichtung nach den Ansprüchen 5 und 6, **dadurch gekennzeichnet**, daß
die nichtzentrisch abbildenden Funktionselemente **(5, 11)** Zylinderlinsen **(5, 11)** sind, und derart
im Strahlengang angeordnet sind, daß
zuerst der größte Öffnungswinkel jedes Strahls und dann der kleinste kollimierbar ist.

9. Vorrichtung nach Anspruch 8, **dadurch gekennzeichnet**, daß
die Achsen der Zylinderlinsen **(5, 11)** zueinander parallel angeordnet sind.

10. Vorrichtung nach einem der Ansprüche 4 bis 9 mit einem oder mehreren Diodenlaserarrays, deren Strahlung in einem Raumbereich **(3)** abgebildet wird.

11. Vorrichtung mit mindestens zwei Reihen Strahlungsquellen nach einem der Ansprüche 4 bis 10, **gekennzeichnet durch**
mindestens einen Spiegelkamm, der die Strahlen jeweils zweier Reihen von Strahlungsquellen nach dem optischen Bauteil für die Bilddrehung und den nichtzentrischen abbildenden Funktionselementen zusammenfügt.

## Claims

1. A process for the focusing into a given spatial zone (3) of a plurality of radiation sources (1) which are arranged in one row or a plurality of rows,
which possess a non-rotation-symmetrical beam cross-section and which ore oriented such that in each case their largest beam quality product occurs in the direction in which the radiation sources of a row are arranged, where beam quality product is to be understood as the product of the radial dimension of the beam (9) at the source and the numerical aperture, in which process the non-rotation-symmetrical beam cross-section of the beam from each radiation source, on passing through an optical component (7), is converted into a position which corresponds to a rotation by the angle enclosed by the direction of the largest with the direction of the smallest beam quality product of each radiation source.

2. A process as claimed in Claim 1, wherein at least one first focusing step is carried out non-centrally before the image rotation of each beam (9).

3. A process as claimed in Claim 2 with which the radiation (9) of at least one diode array (1) is focused, wherein the rays of the diode beam (9) are collimated in the first focusing step in the direction of the smallest beam quality product and are then conveyed through the optical component (7) and then are collimated in the direction of the largest beam quality product rotated by the angle of rotation and focused into a spatial zone (3).

4. A device for the focusing into a given spatial zone (3) of a plurality of radiation sources (1) which are arranged in one row or a plurality of rows, which possess a non-rotation-symmetrical beam cross-section with a largest and a smallest beam opening angle and which are oriented such that in each case their largest beam quality product occurs in the direction in which the radiation sources of a row are arranged where beam quality product is to be understood as the product of the radial dimension of the beam (9) at the source with the numerical aperture,
comprising at leat one first and one second focusing function element (5, 11, 15), characterised in that for each radiation source (1) an optical component (7) for an image rotation is provided which is arranged such that following the passage of the beam (9) through the component (7) the non-rotation-symmetrical beam cross-section appears rotated by approximately the angle, in particular 90°, enclosed by the direction of the largest with the direction of the smallest beam quality product of the radiation source (1).

5. A device as claimed in Claim 4, characterised in that between the radiation sources (1) and the optical component (7), in particular a reversing prism, is arranged the first non-centrally focusing function element (5) with which it is possible to reduce the opening angle in the direction of the smallest beam quality product of each radiation source (1) i.e. the largest beam opening angle.

6. A device as claimed in Claim 4 or 5, characterised in that between the optical component (7) and the spatial zone (3) is arranged the second, non-centrally focusing function element (11) with which it is possible to reduce the smallest beam opening angle issuing from the source (1).

7. A device as claimed in Claim 6, characterised in that between the spatial zone (3) and the second function element (11) there is arranged a centrally focusing function element (15) for focusing the beam (9) into the spatial zone (3).

8. A device as claimed in Claims 5 and 6, characterised in that the non-centrally focusing function elements (5, 11) are cylindrical lenses (5, 11) and are arranged in the beam path in such manner that firstly the largest opening angle of each beam and then the smallest can be collimated.

9. A device as claimed in Claim 8, characterised in that the axes of the cylindrical lenses (5, 11) are arranged in parallel to one another.

10. A device as claimed in one of Claims 4 to 9 with one or more diode laser arrays, the radiation of which is focused into a spatial zone (3).

11. A device with at least two rows of radiation sources as claimed in one of Claims 4 to 10, characterised by at least one mirror comb which unites the beams of in each case two rows of radiation sources following the optical component for the image rotation and the non-centrally focusing function elements.

## Revendications

1. Procédé de formation de l'image de plusieurs sources (1) de faisceau dans un domaine spatial prédéterminé (3),
qui sont disposées en une au plusieurs colonnes,
qui présentent une section transversale de faisceau sans symétrie de rotation et
qui sont orientées d'une manière telle
que le produit maximal des paramètres du faisceau est atteint dans la direction
dans; laquelle les sources de faisceau sont disposées en une colonne,
étant entendu que l'on désigne par produit des paramètres du faisceau le produit de l'étendue radiale du faisceau (9) à la source par l'ouverture numérique,
procédé dans lequel la section transversale du faisceau sans symétrie de rotation de faisceau qui provient de chacune des sources de faisceau est amené à la traversée d'un composant optique (7) dans une position qui correspond pour chaque source de faisceau à une rotation d'un angle égal à l'angle inclus entre la direction du produit maximal des paramètres du faisceau et la direction du produit minimal des paramètres du faisceau.

2. Procédé selon la revendication 1, dans lequel au moins une première étape de formation d'image est exécutée de façon non centrée avant la rotation d'image de chaque faisceau (9) de rayons.

3. Procédé selon la revendication 2, par lequel l'image au moins du faisceau (9) d'un réseau (1) de diodes est formée, dans lequel
les rayons du faisceau (9) de diodes sont collimatés, dans la première étape de formation d'image, dans la direction du produit minimal des paramètres du faisceau, puis sont guidés à travers le composant optique (7) et sont ensuite collimatés dans la direction, tournée de l'angle de rotation, du produit maximal des paramètres du faisceau et sont focalisé dans un domaine spatial (3).

4. Dispositif de formation de l'image de plusieurs sources (1) de faisceau dans un domaine spatial prédéterminé (3),
qui sont disposées en une ou plusieurs colonnes,
qui présentent une section transversale de faisceau sans symétric de rotation, à angle maximal et à angle minimal d'ouverture de faisceau et
qui sont orientées d'une manière telle
que le produit maximal des paramètres du faisceau est atteint dans la direction
dans laquelle les sources de faisceau sont disposées en une colonne,
étant entendu que l'on désigne par produit des paramètres du faisceau le produit de l'étendue radiale du faisceau (9) à la source par l'ouverture numérique,
se composent d'au moins un premier et un deuxième éléments fonctionnels (5, 11, 15) de formation d'image, caractérisé en ce que
il est prévu pour chaque source de faisceau (1) un composent optique (7) de rotation d'image,
qui est agencé d'une manière telle que
la section transversale de faisceau sans symétrie de rotation semble, quand le faisceau (9) a traversé le composant (7), tournée d'environ d'un angle, en particulier de 90°, qui est inclus entre la direction du produit maximal des paramètres de faisceau et la direction du produit minimal des paramètres de faisceau de la source (1) de faisceau.

5. Dispositif selon la revendication 4, caractérisé en ce que
le premier élément fonctionnel (5) de formation d'image non centrée,
au moyen duquel l'angle d'ouverture peut être réduit dans la direction du produit minimal des paramètres de faisceau de chaque source de faisceau (1), c'est-à-dire l'angle maximal d'ouverture de faisceau,
est disposé entre les sources (1) de faisceau et le composant optique (7), en particulier un prisme à redressement de l'image.

6. Dispositif selon la revendication 4 ou 5, caractérisé en ce que
le deuxième élément fonctionnel (11) de formation d'image non centrée,
au moyen duquel l'angle minimal d'ouverture de faisceau qui provient de la source (1) peut être réduit
est disposé entre le composant optique (7) et le domaine spatial (3).

7. Dispositif selon la revendication 6, caractérisé en ce que
un élément fonctionnel focalisant de façon centrée (15) est disposé entre le domaine spatial (3) et le deuxième élément fonctionnel en vue de focaliser le faisceau (9) de rayons dans le domaine spatial (3).

8. Dispositif selon l'une des revendications 5 ou 6, caractérisé en ce que
les éléments fonctionnels (5, 11) de formation d'image non centrée consistent en lentilles cylindriques (5, 11), et
sont disposés dans le trajet des faisceaux d'une manière telle que
l'angle maximal d'ouverture de chaque faisceau peut être collimaté en premier lieu et l'angle minimal d'ouverture peut ensuite l'être.

9. Dispositif selon la revendication 8, caractérisé en ce que les axes des lentilles cylindriques (5, 11) sont parallèles entre eux.

10. Dispositif selon une des revendications 4 à 9, qui inclut un ou plusieurs réseaux de diodes laser dont l'image de faisceau est formée dans un domaine spatial (3).

11. Dispositif qui comprend au moins deux colonnes de sources de faisceau selon l'une des revendications 4 à 10, caractérisé par
au moins un peigne formant miroir qui rassemble les faisceaux provenant respectivement de deux colonnes de sources de faisceaux, après le composant optique destiné a la rotation d'image et les éléments fonctionnels de formation d'image non centrée.
